# EUROPEAN PATENT APPLICATION

(11) **EP 4 488 813 A1**
(43) Date of publication of application: **08.01.2025**
(21) Application number: 24184225.1
(22) Date of filing: 25.06.2024
(51) Int. Cl.: G06F 3/06, G06F 11/10, G11C 16/34

(54) **STORAGE DEVICES THAT SUPPORT SUB-BLOCK RECLAIM OPERATIONS THEREIN UPON DETECTION OF UNCORRECTABLE ERRORS**

(30) Priority: 05.07.2023 KR 20230087390
(71) Applicant: Samsung Electronics Co., Ltd., Suwon-si, Gyeonggi-do 16677 (KR)
(72) Inventor: PARK, Sang-Won, 16677 Suwon-si (KR); KO, Kuihan, 16677 Suwon-si (KR); SON, Heewon, 16677 Suwon-si (KR)
(74) Representative: Marks & Clerk LLP

(57) **Abstract**

A non-volatile integrated circuit memory device includes a first memory block having first and second memory sub-blocks therein, and a second memory block having third and fourth memory sub-blocks therein. A sub-block manager is also provided, which is configured to: (i) determine whether the second memory sub-block is a reclaim sub-block when the first memory sub-block has an uncorrectable error therein, and (ii) reclaim the first and second memory sub-blocks to the third and fourth memory sub-blocks, respectively, in response to determining that the second memory sub-block is a reclaim sub-block.

## Description

### BACKGROUND

Example embodiments of the present disclosure described herein relate to integrated circuit devices and, more particularly, to integrated circuit memory devices having increased reliability in response to improved error monitoring and data protection.

Semiconductor memory devices may typically be classified as volatile memory devices or non-volatile memory devices. As will be understood by those skilled in the art, volatile memories (e.g., a dynamic random access memory (DRAM) or a static random access memory (SRAM)) may exhibit faster read and/or write speeds when compared to non-volatile memories. However, data stored in volatile memories may disappear when power applied thereto is turned off. In contrast, non-volatile memories may retain the data even when the power is turned off. A representative example of a non-volatile memory may be a flash-type memory. A flash-type memory may store multi-bit data of two or more bits in one memory cell. In addition, memory cells in a flash-type memory may have at least one erase state and a plurality of program (e.g., writing) states depending on threshold voltage distributions.

A flash memory cell typically has a read margin between each program state, but the threshold voltage of a flash memory cell may change due to various reasons. For example, the threshold voltage of a flash memory cell(s) may change due to coupling noise, pass voltage disturbance, program voltage disturbance, or read pass voltage disturbance. Furthermore, if the threshold voltage of a memory cell rises, a first program state may overlap with a second program state. As a result, a read failure may occur during a read operation. An uncorrectable error (UECC) may also occur when an excessive number of errors in cells are present.

### SUMMARY

Example embodiments of the present disclosure provide a storage device capable of determining in advance whether to reclaim other sub-blocks in the same memory block when an uncorrectable error occurs in one sub-block in a memory block and to reclaim the sub-block.

Example embodiments of the present disclosure provide a storage device capable of reducing performance degradation due to uncorrectable errors by performing a reclaim operation.

According to an embodiment, a storage device comprises: a first memory block configured to include first and second sub-blocks, and a second memory block configured to include third and fourth sub-blocks. And, in the event the first sub-block includes an uncorrectable error (UECC), the storage device is configured to determine whether the second sub-block is a reclaim sub-block. Then, if the second sub-block is determined to be a reclaim sub-block, the storage device is configured to reclaim the first and second sub-blocks to the third and fourth sub-blocks, respectively.

According to another embodiment, a storage device includes a first memory block configured to include first to third sub-blocks, and a second memory block configured to include fourth to sixth sub-blocks. The second sub-block may be a using sub-block and the third sub-block may be a not-used sub-block. Then, if the first sub-block contains an uncorrectable error (i.e., the first sub-block is a (UECC) sub-block), the storage device is configured to reclaim the first to third sub-blocks to the fourth to sixth sub-blocks, respectively.

According to a further embodiment, a storage device includes a memory device, which is configured to include a first memory block having first and second sub-blocks and a second memory block having third and fourth sub-blocks. A memory controller is provided, which is configured to control the memory device; and, if the first sub-block is an uncorrectable error (UECC) sub-block (i.e., the first sub-block includes an uncorrectable error), the memory controller is configured to reclaim the first and second sub-blocks to the third and fourth sub-blocks, respectively, when the second sub-block is a using sub-block.

According to an additional embodiment, a non-volatile integrated circuit memory device is provided, which includes a first memory block having first and second memory sub-blocks therein, and a second memory block having third and fourth memory sub-blocks therein. A sub-block manager is also provided, which is configured to: (i) determine whether the second memory sub-block is a reclaim sub-block when the first memory sub-block has an uncorrectable error (UECC) therein, and then (ii) reclaim the first and second memory sub-blocks to the third and fourth memory sub-blocks, respectively, in response to determining that the second memory sub-block is a reclaim sub-block. Thereafter, the first and second memory sub-blocks may be erased in response to reclamation of the first and second memory sub-blocks.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram illustrating an example embodiment of a storage device according to the present disclosure.
FIG. 2 is a block diagram illustrating as an example embodiment of the memory device shown in FIG. 1.
FIG. 3 is a circuit diagram illustrating an example embodiment of a memory block BLK1 of the memory cell array illustrated in FIG. 2.
FIG. 4 is a circuit diagram illustrating cell strings selected by the first string selection line SSL1 from among the cell strings of the memory block BLK1 illustrated in FIG. 3.
FIG. 5 is a diagram illustrating an example embodiment of threshold voltage distributions of memory cells illustrated in FIG. 4.
FIG. 6 is a block diagram illustrating an example embodiment of the memory controller in FIG. 1.
FIG. 7 is a flowchart illustrating a sub-block reclaim operation method of the sub-block managing module shown in FIG. 6.
FIG. 8 is a diagram illustrating an example embodiment of the sub-block reclaim operation and sub-block erase operation described in FIG. 7.
FIGS. 9 and 10 are a flowchart and a diagram illustrating an example embodiment in which the sub-block managing module shown in FIG. 6 designates all sub-blocks as reclaim sub-blocks.
FIGS. 11 and 12 are a flowchart and a diagram illustrating an example embodiment of designating a using sub-block by the sub-block managing module shown in FIG. 6 as a reclaim sub-block.
FIGS. 13 to 16 are a flowchart and diagrams illustrating an example embodiment in which the sub-block managing module shown in FIG. 6 designates a reclaim sub-block based on the number of error bits of the sub-blocks.
FIGS. 17 and 18 are a flowchart and a diagram illustrating an example embodiment of a sub-block erase operation of the sub-block managing module shown in FIG. 6.
FIG. 19 is a diagram illustrating an example embodiment of a flash memory having a multi-stack structure.
FIG. 20 is a block diagram illustrating an example in which a storage device according to an embodiment of the present disclosure is implemented with a solid state drive (SSD).

### DETAILED DESCRIPTION

Below, embodiments of the present disclosure will be described in detail and clearly to such an extent that one of ordinary skill in the art can easily implement the invention.

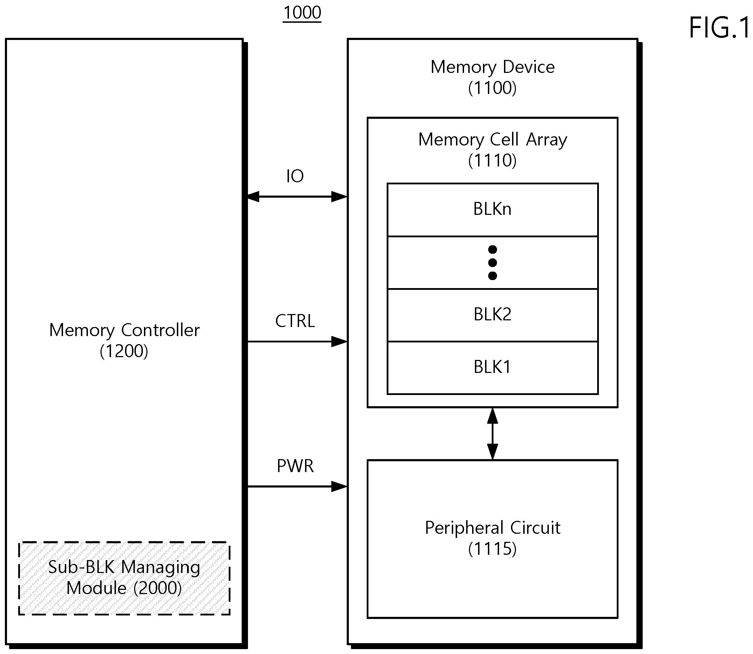

FIG. 1 is a block diagram illustrating an example embodiment of a storage device according to the present disclosure. Referring to FIG. 1, the storage device 1000 may include a memory device 1100 and a memory controller 1200. The memory device 1100 may receive input/output signals IO from the memory controller 1200 through input/output lines, receive control signals CTRL through control lines, and receive external power supply PWR through power lines. The storage device 1000 may store data in the memory device 1100 under the control of the memory controller 1200.

As shown, the memory device 1100 may include a memory cell array 1110 and a peripheral circuit 1115. The memory cell array 1110 includes a plurality of memory blocks BLK1 to BLKn. Each memory block may have a vertical 3D structure to achieve a high storage capacity. Each memory block may include a plurality of memory cells. Multi-bit data may be stored in each memory cell.

The memory cell array 1110 may be located (e.g., disposed) next to or above the peripheral circuit 1115 in terms of the design layout structure. A structure in which the memory cell array 1110 is positioned over the peripheral circuit 1115 (i.e., vertically integrated) may be referred to as a cell on peripheral (COP) structure. In one example embodiment, the memory cell array 1110 may be manufactured as a chip separate from the peripheral circuit 1115. An upper chip including the memory cell array 1110 and a lower chip including the peripheral circuit 1115 may be connected to each other by a bonding method. Such a structure may be referred to as a chip-to-chip (C2C) structure.

In some embodiments, the peripheral circuit 1115 may include analog circuits and/or digital circuits required to store data in the memory cell array 1110 or read data stored in the memory cell array 1110. The peripheral circuit 1115 may receive the external power PWR through power lines and generate internal powers of various levels. The peripheral circuit 1115 may receive commands, addresses, and/or data from the memory controller 1200 through input/output lines. The peripheral circuit 1115 may store data in the memory cell array 1110 according to the control signals CTRL. Alternatively or additionally, the peripheral circuit 1115 may read data stored in the memory cell array 1110 and provide the read data to the memory controller 1200.

As shown, the memory controller 1200 may include a sub-block managing module 2000, as described more fully hereinbelow. Advantageously, when an uncorrectable error (UECC) occurs in the first sub-block of the first memory block BLK1 and the second sub-block is determined to be a reclaim sub-block (a sub-block to be reclaimed in a reclaiming operation), the sub-block managing module 2000 can reclaim the first and second sub-blocks to the second memory block BLK2.

As will be understood by those skilled in the art, when one sub-block is read repeatedly, error bits may increase therein due to various problems, such as read disturbance. Then, when an uncorrectable error (UECC) occurs in the data stored in the first sub-block, an operation of moving the data stored in the second sub-block to the second memory block is performed, and referred to herein as a sub-block reclaim operation. Advantageously, the sub-block managing module 2000 manages a sub-block reclaim operation of the memory device 1100.

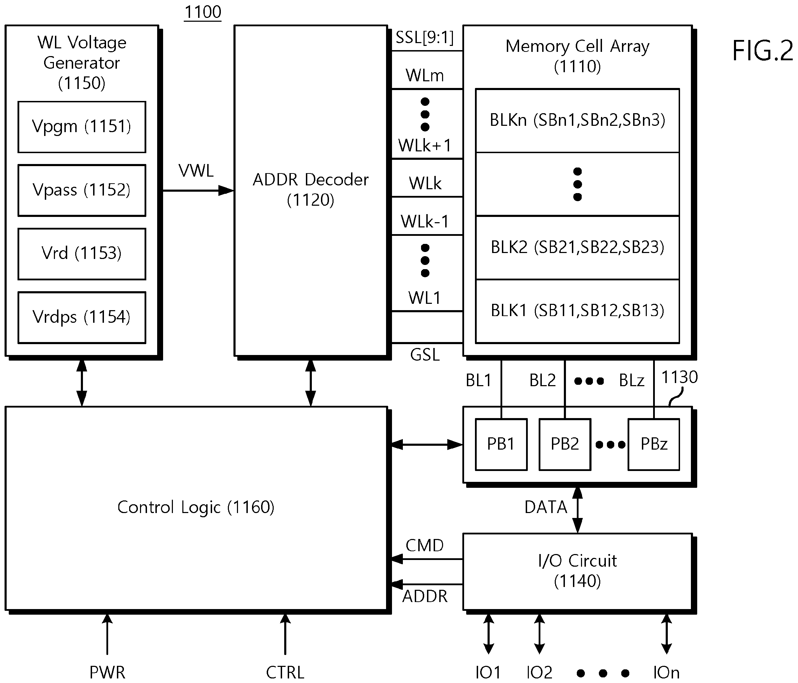

FIG. 2 is a block diagram illustrating as an example embodiment of the memory device shown in FIG. 1. The storage device 1000 may be a flash storage device based on a flash memory. For example, the storage device 1000 may be implemented as a solid-state drive (SSD), a universal flash storage (UFS), a memory card, or the like. Referring to FIGS. 1 and 2, the memory device 1100 may include the memory cell array 1110 and the peripheral circuit 1115 (see FIG.1). The peripheral circuit 1115 may include an address decoder 1120, a page buffer circuit 1130, a data input/output circuit 1140, a word line voltage generator 1150, and a control logic 1160.

The memory cell array 1110 includes a plurality of memory blocks BLK1 to BLKn. Each memory block includes a plurality of sub-blocks. For example, the first memory block BLK1 includes the first to third sub-blocks SB11, SB12, and SB13. The second memory block BLK2 includes the fourth to sixth sub-blocks SB21, SB22, and SB13. SB23). The n-th memory block BLKn may include sub-blocks SBn1, SBn2, and SBn3. In addition, each sub-block may be connected to a plurality of word lines. Each word line may be composed of one or more pages. Each page may include a plurality of memory cells. Each memory cell may store multi-bit data (e.g., two or more bits). Each memory block or sub-block may be an erase unit. Each page may be a read or write unit.

The memory cell array 1110 may be formed in a direction perpendicular to a substrate (i.e., vertically). A gate electrode layer and an insulation layer may be alternately deposited on the substrate. Each memory block (e.g., BLK1) may be connected to one or more string selection lines SSL, a plurality of word lines WL1 to WLm, and one or more ground selection lines GSL. WLk is a selected word line sWL and the remaining word lines (WL1 to WLk-1, WLk+1 to WLm) are unselected word lines uWL.

The address decoder 1120 may be connected to the memory cell array 1110 through selection lines SSL and GSL and word lines WL1 to WLm. The address decoder 1120 may select a word line during a program or read operation. The address decoder 1120 may receive the word line voltage VWL from the word line voltage generator 1150 and provide a program voltage or read voltage to the selected word line.

The page buffer circuit 1130 may be connected to the memory cell array 1110 through bit lines BL1 to BLz. The page buffer circuit 1130 may temporarily store data to be written into the memory cell array 1110 or data that is read from the memory cell array 1110. The page buffer circuit 1130 may include page buffers PB1 to PBz connected to respective bit lines, and each page buffer may include a plurality of latches to store or read multi-bit data.

The input/output circuit 1140 may be internally connected to the page buffer circuit 1130 through data lines and externally connected to the memory controller (refer to FIG. 1, 1200) through the input/output lines IO1 to IOn. The input/output circuit 1140 may receive program data from the memory controller 1200 during a program operation. Also, the input/output circuit 1140 may provide data read from the memory cell array 1110 to the memory controller 1200 during a read operation.

The word line voltage generator 1150 may receive internal power from the control logic 1160 and generate a word line voltage VWL required to read or write data. The word line voltage VWL may be provided to a selected word line (sWL) or unselected word lines (uWL) through the address decoder 1120.

The word line voltage generator 1150 may include a program voltage generator 1151 and a pass voltage generator 1152. The program voltage generator 1151 may generate a program voltage Vpgm provided to the selected word line sWL during a program operation. The pass voltage generator 1152 may generate a pass voltage Vpass provided to the selected word line sWL and the unselected word lines uWL.

The word line voltage generator 1150 may include a read voltage generator 1153 and a read pass voltage generator 1154. The read voltage generator 1153 may generate a select read voltage Vrd provided to the select word line sWL during a read operation. The read pass voltage generator 1154 may generate a read pass voltage Vrdps provided to unselected word lines uWL. The read pass voltage Vrdps may be a voltage sufficient to turn on memory cells connected to the unselected word lines uWL during a read operation. The control logic 1160 may control operations such as read, write, and erase of the memory device 1100 using commands CMD, addresses ADDR, and control signals CTRL provided from the memory controller 1200. The addresses ADDR may include a block selection address for selecting one memory block, a row address for selecting one page, and a column address for selecting one memory cell.

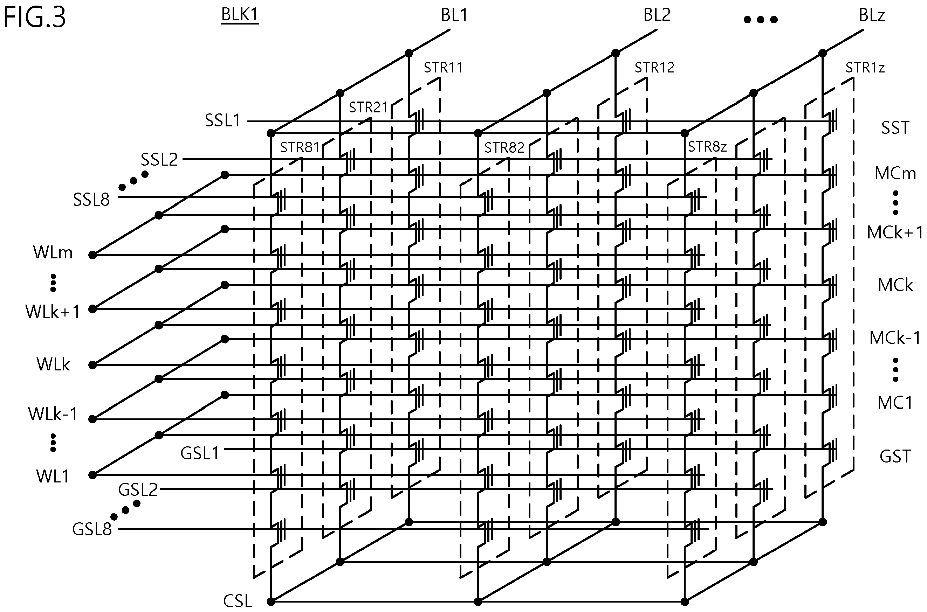

FIG. 3 is a circuit diagram illustrating an example embodiment of a memory block BLK1 of the memory cell array illustrated in FIG. 2. Referring to FIG. 3, in the memory block BLK1, a plurality of cell strings STR11 to STR8z may be formed between the bit lines BL1 to BLz and a common source line CSL. Each cell string includes a string selection transistor SST, a plurality of memory cells MC1 to MCm, and a ground selection transistor GST.

The string selection transistors SST may be connected with string selection lines SSL1 to SSL8. The ground selection transistors GST may be connected with ground selection lines GSL1 to GSL8. The string selection transistors SST may be connected with the bit lines BL1 to BLz, and the ground selection transistors GST may be connected with the common source line CSL. The first to m-th word lines WL1 to WLm may be connected with the plurality of memory cells MC1 to MCm in a row direction. The first to z-th bit lines BL1 to BLz may be connected with the plurality of memory cells MC1 to MCm in a column direction. First to z-th page buffers PB1 to PBz may be connected with the first to z-th bit lines BL1 to BLz.

The first word line WL1 may be placed above the first to eighth ground selection lines GSL1 to GSL8. The first memory cells MC1 that are placed at the same height from the substrate may be connected with the first word line WL1. The second word line WL2 may be placed above the first word line WL1. The second memory cells MC2 that are placed at the same height from the substrate may be connected with the second word line WL2. In a similar manner, the third to m-th memory cells MC3 to MCm that are placed at the same heights from the substrate may be respectively connected with the third to m-th word lines WL3 to WLm.

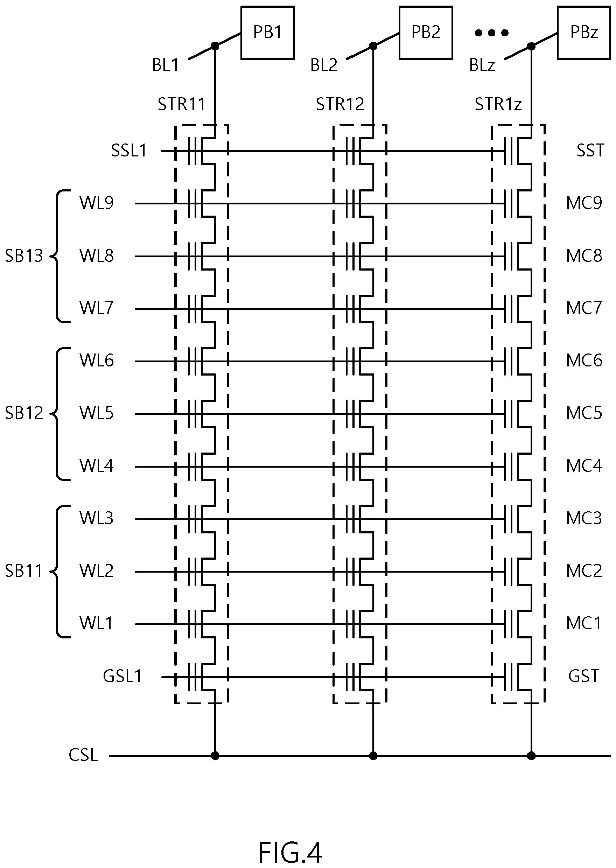

FIG. 4 is a circuit diagram illustrating cell strings selected by the first string selection line SSL1 from among the cell strings of the memory block BLK1 illustrated in FIG. 3. The 11th to 1z cell strings STR11 to STR1z may be selected by the first string selection line SSL1. The eleventh to 1z cell strings STR11 to STR1z may be connected to the first to z -th bit lines BL1 to BLz, respectively. The first to z-th page buffers PB1 to PBz may be connected to the first to z-th bit lines BL1 to BLz, respectively.

The eleventh cell string STR11 may be connected to the first bit line BL1 and the common source line CSL. The eleventh cell string STR11 may include string selection transistors SST selected by the first string selection line SSL1, first to m-th memory cells MC1 to MCm connected to the first to m-th word lines WL1 to WLm, and ground selection transistors GST selected by the first ground selection line GSL1. The twelfth cell string STR12 may be connected to the second bit line BL2 and the common source line CSL. The 1z cell string STR1z may be connected to the z-th bit line BLz and the common source line CSL.

The first word line WL1 and the m-th word line WLm may be edge word lines (edge WL). The second word line WL2 and the (m-1)-th word line WLm-1 may be edge adjacent word lines. The k-th word line WLk may be a selected word line sWL. The (k-1)-th word line WLk-1 and the (k+1)-th word line WLk+1 may be adjacent word lines adjacent to the selected word line. If the k-th word line WLk is the selected word line sWL, the remaining word lines WL1 to WLk-1 and WLk+1 to WLm may be unselected word lines uWL.

The first memory cells MC1 and the m-th memory cells MCm may be edge memory cells. The second memory cells MC2 and the (m-1)-th memory cells MCm-1 may be edge adjacent memory cells. The k-th memory cells MCk may be selected memory cells sMC. The (k-1)-th memory cells MCk-1 and the (k+1)-th memory cells MCk+1 may be memory cells adjacent to the selected memory cells (adjacent MC). If the k-th memory cells MCk are selected memory cells sMC, the remaining memory cells MC1 to MCk-1 and MCk+1 to MCm may be unselected memory cells uMC.

A set of memory cells selected by one string selection line and connected to one word line may be one page. For example, memory cells selected by the first string selection line SSL1 and connected to the k-th word line WLk may be one page. For example, eight pages may be configured on the k-th word line WLk. Among the eight pages, a page connected to the first string selection line SSL1 is a selected page, and pages connected to the second to eighth string selection lines SSL2 to SSL8 are unselected pages.

The first memory block BLK1 may include a plurality of smaller sub-blocks SB11, SB12, and SB13. Each sub-block SB11, SB12, and SB13 may be divided in the word line direction. Regardless of the criteria by which the sub-blocks are divided, each sub-block may be erased independently from other sub-blocks in the first memory block BLK1. As shown, the sub-block SB11 may be memory cells connected to the first to third word lines WL1, WL2, and WL3 among memory cells included in the first memory block BLK1; the sub-block SB12 may be memory cells connected to the fourth to sixth word lines WL4, WL5, and WL6 among the memory cells included in the first memory block BLK1; and the sub-block SB13 may be memory cells connected to the seventh to ninth word lines WL7, WL8, and WL9 among the memory cells included in the first memory block BLK1. One or more than two of the sub-blocks SB1, SB2, and SB3 may be selected and erased simultaneously. The word line voltage generator 1150 of FIG. 2 may provide bias voltage for erasing memory cells in a sub-block unit.

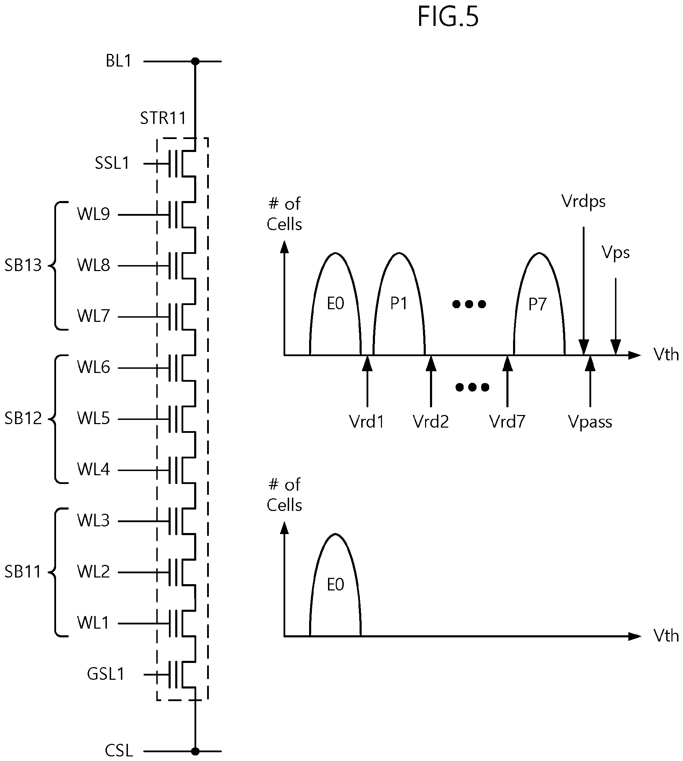

FIG. 5 is a diagram illustrating an example embodiment of threshold voltage distributions of memory cells illustrated in FIG. 4. The horizontal axis represents the threshold voltage Vth, and the vertical axis represents the number of memory cells. FIG. 5 shows an example in which 3-bit data is stored in one memory cell. A 3-bit memory cell may have one of eight states (E0, P1 to P7) according to the threshold voltage distribution. E0 represents an erase state, and P1 to P7 represent program states (associated with different "cell" threshold voltages).

During a read operation, the selection read voltages Vrd1 to Vrd7 may be provided to the selected word line sWL, and the pass voltage Vps and/or the read pass voltage Vrdps may be provided to the unselected word lines uWL. The pass voltage Vps and/or the read pass voltage Vrdps may be a voltage sufficient to turn on the memory cells. For example, the pass voltage Vps may be provided to the adjacent word lines WLkt1, and the read pass voltage Vrdps may be provided to the unselected word lines other than the adjacent word lines.

The first selection read voltage Vrd1 may be a voltage level between the erase state E0 and the first program state P1. The second selection read voltage Vrd2 may be a voltage level between the first and second program states P1 and P2. In this way, the seventh selection read voltage Vrd7 may be a voltage level between the sixth and seventh program states P6 and P7. As will be understood by those skilled in the art, when the first selection read voltage Vrd1 is applied, the memory cell in the erase state E0 may be an on cell and the memory cell in the first to seventh program states P1 to P7 may be an off cell. When the second selection read voltage Vrd2 is applied, the memory cell in the erase state E0 and the first program state P1 may an on cell, and the memory cell in the second to seventh program states P2 to P7 may an off cell. In this way, when the seventh selection read voltage Vrd7 is applied, the memory cell in the erase state E0 and the first to sixth program states P1 to P6 may be an on cell and the memory cell in the seventh program state P7 may be an off cell.

During a read operation, a power supply voltage may be applied to the string selection line SSL1 and the ground selection line GSL1, and the string select transistor SST and the ground select transistor GST may be turned on. Also, the selection read voltage Vrd may be provided to the selected word line sWL, and the read pass voltage Vrdps and/or the pass voltage Vps may be provided to the unselected word lines uWL.

When repeatedly reading the selected word line of sub-block SB11, a high-voltage pass voltage Vps or a read pass voltage Vrdps may be repeatedly provided to the remaining word lines. At this time, a significant read disturbance can occur in the sub-blocks SB11, SB12, and SB13 in the first memory block BLK1, and thereby cause the threshold voltage of memory cells in the erase state E0 to increase and enter the program state. When this occurs, the threshold voltage may be distorted and an uncorrectable error (UECC) may occur.

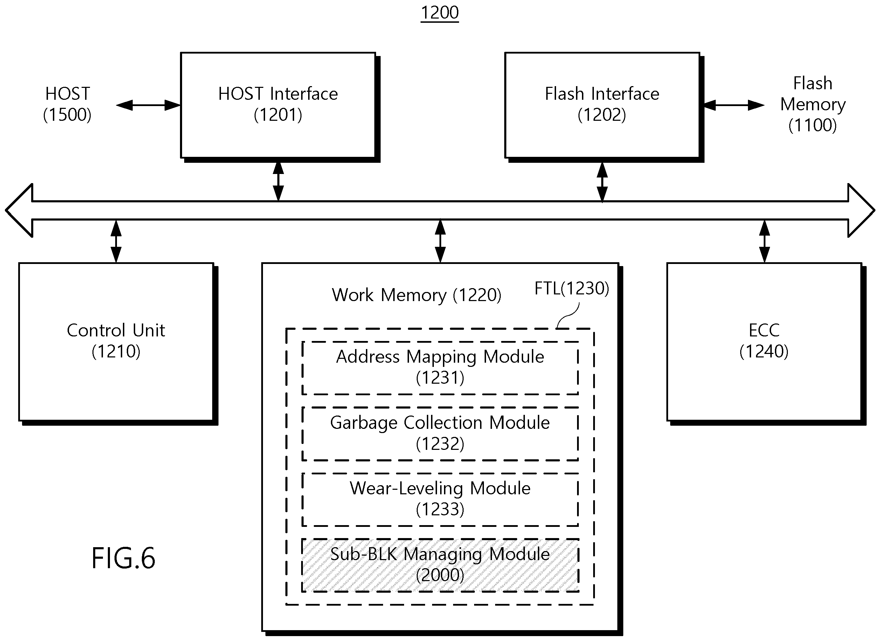

FIG. 6 is a block diagram illustrating an example embodiment of the memory controller in FIG. 1. Referring to FIG. 6, the memory controller 1200 may include a host interface 1201, a flash interface 1202, a control unit 1210, a work memory 1220, and an ECC circuit 1240. The work memory 1220 may drive a flash translation layer (FTL) 1230. In addition, the memory controller 1200 may further include various components, such as a buffer memory that temporarily stores data resulting from a read or write operation of the flash memory 1100, a buffer control module for controlling the buffer memory, or a command generation module for generating a command (CMD) for controlling a memory operation according to a request from the host 1500, etc.

The host interface 1201 may provide an interface between the host 1500 and the memory controller 1200. Standard interfaces may include various interface methods such as advanced technology attachment (ATA), serial ATA (SATA), external SATA (e-SATA), small computer small interface (SCSI), serial attached SCSI (SAS), peripheral component interconnection (PCI), PCI express (PCI-E), IEEE 1394, universal serial bus (USB), secure digital card (SD), multi-media card (MMC), embedded multi-media card (eMMC), universal flash storage (UFS), compact flash (CF), etc.

The flash interface 1202 may provide an interface between the flash memory 1100 and the memory controller 1200. For example, write or read data may be transmitted to and received from the flash memory 1100 through the flash interface 1202. The flash interface 1202 may provide commands and addresses to the flash memory 1100. The flash interface 1202 may provide data read from the flash memory 1100 to the memory controller 1200.

The control unit 1210 may include a central processing unit or microprocessor, and may control the overall operation of the memory controller 1200. The control unit 1210 may drive firmware loaded in the work memory 1220 to control the memory controller 1200. The work memory 1220 may be implemented with various types of memory, such as DRAM, SRAM, or PRAM. The work memory 1220 may drive the flash translation layer (FTL) 1230 under the control of the control unit 1210. The flash translation layer 1230 may be loaded from flash memory to the work memory 1220 during a boot operation of the storage device. The flash translation layer 1230 may include an address mapping module 1231, a garbage collection module 1232, a wear-leveling module 1233, and a sub-block managing module 2000 depending on the function implemented by firmware.

The address mapping module 1231 may perform address mapping operations on a page-by-page or block-by-block basis. The page address mapping operation is an operation that converts a logical page address received from the file system into a physical page address in the flash memory 1100. For this purpose, a page-level address mapping table must be maintained in the work memory 1220. The page address mapping operation may provide excellent garbage collection performance, but require a large address mapping table.

The block address mapping operation is an operation that converts a logical block address received from the file system into a physical block address in the flash memory 1100. Pages belonging to the same logical block may belong to the same physical block. For this purpose, the block address mapping operation must maintain a block-level address mapping table in the work memory 1220. Block address mapping operations require a small address mapping table, but additional garbage collection operations may be performed.

The flash translation layer 1230 may perform a hybrid mapping operation that combines the advantages of a page address mapping operation and a block address mapping operation. The flash translation layer 1230 may perform a hybrid mapping operation based on the log buffer. The log buffer-based hybrid mapping operation requires a small memory space while providing excellent garbage collection performance.

The garbage collection module 1232 may perform a garbage collection operation by referring to the address mapping table. The garbage collection module 1232 may use an address mapping table to secure one or more free blocks. The garbage collection module 1232 may move one or more valid data stored in a source block to a target block using the address mapping table. The garbage collection module 1232 may make a free block by erasing the source block to which all valid data has been moved.

The wear-leveling module 1233 may manage the wear-level of memory cells of the flash memory 1100. Memory cells may be deteriorated by write and erase operations, etc. Deteriorated memory cells may cause defects. The wear-leveling module 1233 may prevent specific cell areas from wearing out faster than other cell areas by managing program-erase cycles for the memory cell array. The wear-leveling module 1233 may control the address mapping module 1231 so that program and erase times are equally assigned to cell areas of the memory cell array.

The ECC circuit 1240 may generate an error correction code (ECC) to correct fail bits or error bits of data received from the flash memory 1100. The ECC circuit 1240 may perform error correction encoding on data provided to the flash memory 1100 to form data to which a parity bit is added. Parity bits may be stored in flash memory 1100. The ECC circuit 1240 may also perform error correction decoding on data output from the flash memory 1100. The ECC circuit 1240 may correct errors using parity. The ECC circuit 1240 may correct errors using coded modulation, such as low density parity check (LDPC) code, BCH code, turbo code, Reed-Solomon code, convolution code, recursive systematic code (RSC), trellis-coded modulation (TCM), and block coded modulation (BCM).

The ECC circuit 1240 may have an error correction allowable range or threshold. For example, the ECC circuit 1240 may correct errors of up to 40 bits for 2K bytes of page data. In this case, the maximum allowable range in which the ECC circuit 1240 may correct errors is 40 bits. That is, the ECC circuit 1240 may, for example, not correct errors in the page if errors in more than 40 bits occur. A page whose errors cannot be corrected like this is called a defected page. A memory cell in which an error occurs in a defective page is called a defected cell.

The sub-block managing module 2000 may check the error status of the memory blocks or sub-blocks of the memory cell array 1110. The sub-block managing module 2000 may manage the sub-block reclaim operation and/or sub-block erase operation when an error condition occurs. The sub-block managing module 2000 may designate sub-blocks on which to perform a reclaim operation. The sub-block managing module 2000 may control to perform a sub-block reclaim operation within the flash memory 1100. For example, the sub-block managing module 2000 may determine that one or more memory sub-blocks has a number of errors above a threshold or outside the error correction allowable range, and thereby determine at least one memory sub-block to perform a reclaim operation.

The sub-block managing module 2000 may determine sub-blocks on which to perform an erase operation. The sub-block managing module 2000 may concurrently erase all sub-blocks SB11, SB12, and SB13 in a memory block (e.g., BLK1) or erase only the reclaim sub-blocks. When multiple sub-blocks to be erased are designated, the sub-block managing module 2000 may perform sub-block erase operations concurrently or sequentially.

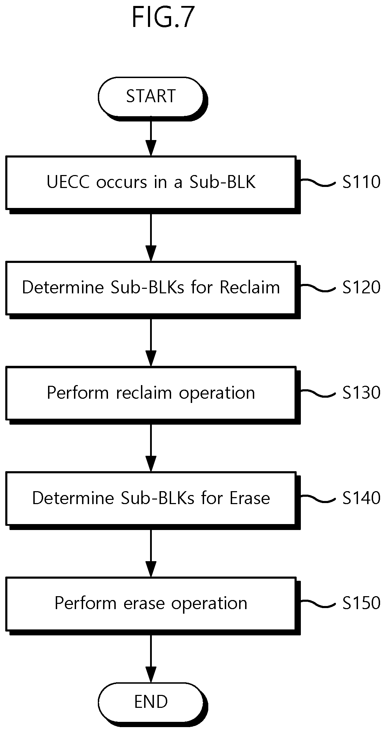

FIG. 7 is a flowchart illustrating a sub-block reclaim operation method of the sub-block managing module shown in FIG. 6. The flash memory 1100 may perform a sub-block reclaim operation and/or a sub-block erase operation under the control of the sub-block managing module 2000. As shown, in operation S110, an UECC may occur in one sub-block of the memory cell array 1110. The sub-block managing module 2000 may check the error status of memory blocks and/or sub-blocks of the memory cell array 1110. The sub-block managing module 2000 may manage a sub-block reclaim operation and/or sub-block erase operation when an uncorrectable error (UECC) occurs.

In operation S120, the sub-block managing module 2000 may determine sub-blocks (hereinafter referred to as reclaim sub-blocks) on which to perform a reclaim operation. The sub-block managing module 2000 may determine the reclaim sub-block in several ways. For example, when UECC occurs in one sub-block (e.g., SB11), the sub-block managing module 2000 may determine whether the remaining sub-blocks (e.g., SB12, SB13) are also reclaim sub-blocks.

The sub-block managing module 2000 may designate all sub-blocks (SB1, SB2, SB3) including the remaining sub-blocks as reclaim sub-blocks. Alternatively, the sub-block managing module 2000 may designate a reclaim sub-block based on the number of error bits in the remaining sub-blocks. For example, if the number of error bits in the remaining sub-block (SB12 or SB13) is greater than the reference number of bits, the corresponding sub-block may be designated as a reclaim sub-block.

In operation S130, the sub-block managing module 2000 may control to perform a sub-block reclaim operation within the flash memory 1100. The flash memory 1100 may receive commands, addresses, and control signals for a sub-block reclaim operation from the memory controller 1200 and perform a sub-block reclaim operation. If a plurality of reclaim sub-blocks are designated, the sub-block reclaim operation may be performed concurrently or sequentially.

In operation S140, the sub-block managing module 2000 may determine sub-blocks on which to perform an erase operation (hereinafter referred to as erase sub-blocks). The sub-block managing module 2000 may determine an erase sub-block in several ways. For example, the sub-block managing module 2000 may erase all sub-blocks SB11, SB12, and SB13 within a memory block (e.g., BLK1) or erase only reclaim sub-blocks.

In operation S150, the sub-block managing module 2000 may control the flash memory 1100 to perform a sub-block erase operation. The flash memory 1100 may receive commands, addresses, and control signals for a sub-block erase operation from the memory controller 1200 and perform a sub-block erase operation. When multiple erase sub-blocks are designated, the sub-block erase operation may be performed concurrently or sequentially.

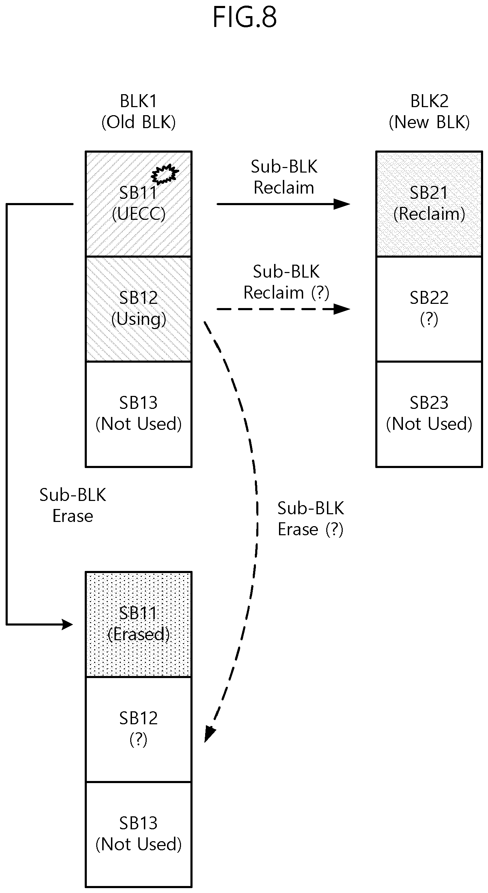

FIG. 8 is a diagram illustrating an example embodiment of the sub-block reclaim operation and sub-block erase operation described in FIG. 7. Referring to FIG. 8, the first memory block (BLK1) may include three sub-blocks (SB11, SB12, SB13). The second memory block (BLK2) may include three sub-blocks (SB21, SB22, SB23). The first memory block (BLK1) may be an old block (Old BLK) where UECC occurred. The second memory block (BLK2) may be a new block (New BLK) to which data will be moved through a reclaim operation. UECC may occur in sub-block SB11 of the first memory block BLK1. In sub-block SB12, some pages are programmed and the remaining pages are in an erased state. That is, sub-block SB12 may be a using sub-block (in-use sub-block, or a programmed sub-block). The sub-block SB13 has not yet been programmed, and all pages are in an erased state. That is, sub-block SB13 may be an unused sub-block (Not Used Sub-BLK).

When a UECC occurs in sub-block SB11 of the first memory block BLK1, the sub-block managing module 2000 may determine whether the remaining sub-blocks SB12 and SB13 are reclaim sub-blocks. The sub-block managing module 2000 may designate all sub-blocks SB1, SB2, and SB3 in the first memory block BLK1 as reclaim sub-blocks. Alternatively, according to another embodiment, the sub-block managing module 2000 may designate the using sub-block SB12 as a reclaim sub-block, but not designate the not-used sub-block SB13 as a reclaim sub-block.

Furthermore, according to a further embodiment, the sub-block managing module 2000 may designate the using sub-block SB12 as a reclaim sub-block based on a specific criterion. In some instances, the specific criteria may be multiple. For example, a "using" sub-block may be designated as a reclaim sub-block based on the number of error bits in memory cells connected to a specific word line (of the using sub-block SB12). If the number of error bits in the using sub-block (SB12) is greater than the threshold, and therefore more likely to ultimately develop a UECC over time, it may be designated as a reclaim sub-block. Here, the threshold may be fixed regardless of the program-erase cycle, or may be adjusted upward depending on the program-erase cycle. Alternatively, the threshold may vary depending on whether the sub-block is using, or is not used (e.g., fully erased).

If the using sub-block SB12 is not designated as a reclaim sub-block, the sub-block managing module 2000 may reclaim only the reclaim sub-blocks SB11 to the second memory block BLK2. However, if the using sub-block SB12 is designated as a reclaim sub-block, the sub-block managing module 2000 may reclaim all of the reclaim sub-blocks SB11 and SB12 to the second memory block BLK2.

After the sub-block reclaim operation is performed, the sub-block managing module 2000 may perform a sub-block erase operation on the first memory block BLK1. The sub-block managing module 2000 may determine an erase sub-block. The sub-block managing module 2000 may erase all sub-blocks SB11, SB12, and SB13 in the first memory block BLK1 concurrently or sequentially.

Alternatively, the sub-block managing module 2000 may erase the reclaim sub-block. For example, if the using sub-block SB12 is not designated as a reclaim sub-block, the sub-block managing module 2000 may erase only the reclaim sub-block SB11. If the using sub-block SB12 is designated as a reclaim sub-block, the sub-block managing module 2000 may erase the reclaim sub-blocks SB11 and SB12. The sub-block managing module 2000 may erase the reclaim sub-blocks SB11 and SB12 concurrently or sequentially.

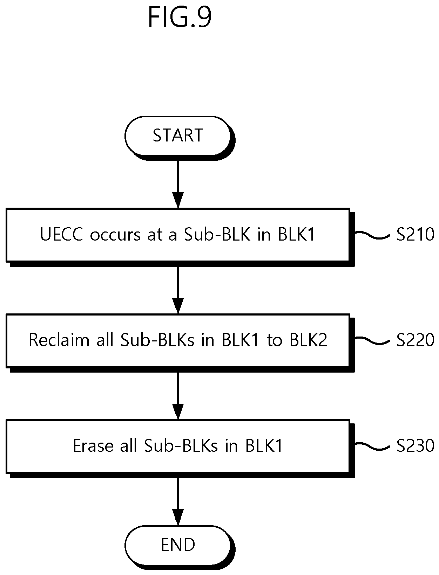

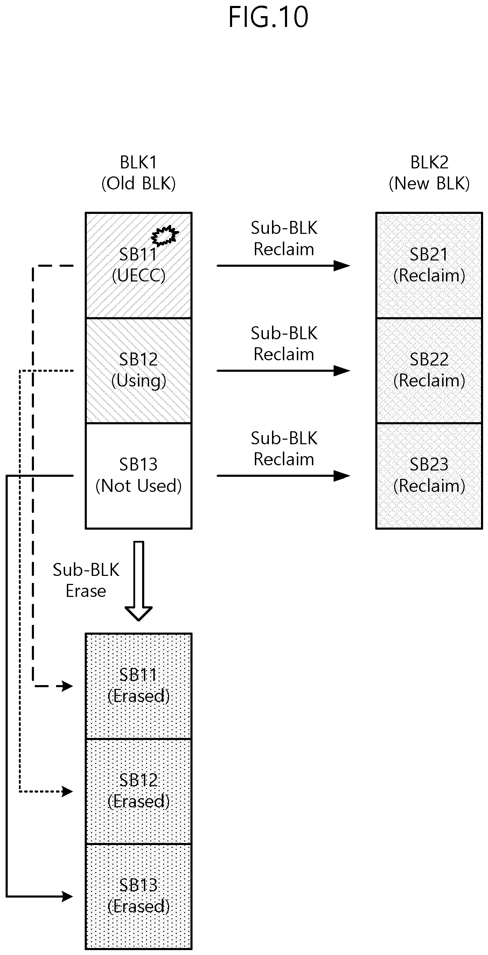

FIGS. 9 and 10 are a flowchart and a diagram illustrating an example embodiment in which the sub-block managing module shown in FIG. 6 designates all sub-blocks as reclaim sub-blocks. Referring to FIG. 10, the first memory block BLK1 may include three sub-blocks SB11, SB12, and SB13. The second memory block BLK2 may include three sub-blocks SB21, SB22, and SB23. As described herein, the flash memory 1100 may reclaim all sub-blocks in the first memory block BLK1 to the second memory block BLK2 under the control of the sub-block managing module 2000. Additionally, the sub-block managing module 2000 may erase all sub-blocks in the first memory block BLK1 concurrently or sequentially.

In operation S210, a UECC may occur in one sub-block in the first memory block BLK1. The sub-block managing module 2000 may check error bits of sub-blocks of the first memory block BLK1 and determine that a UECC has occurred (e.g., when the number of error bits exceeds an allowable range). The sub-block managing module 2000 may manage a sub-block reclaim operation and/or a sub-block erase operation of the flash memory 1100 when a UECC occurs in one sub-block.

In operation S220, the sub-block managing module 2000 may designate all sub-blocks in the first memory block BLK1 as reclaim sub-blocks and reclaim them to the second memory block BLK2. If a UECC occurs in sub-block SB11, both the using sub-block SB12 and the not-used sub-block SB13 may be reclaimed to the second memory block (BLK2). Thus, for example, the sub-block SB11 of the first memory block (BLK1) may be reclaimed to sub-block SB21 of the second memory block; the using sub-block SB12 may be reclaimed to sub-block SB22; and the not-used sub-block SB13 may be reclaimed to sub-block SB23.

In operation S230, the sub-block managing module 2000 may perform a sub-block erase operation. The sub-block managing module 2000 may erase all sub-blocks SB11, SB12, and SB13 in the first memory block BLK1 concurrently or sequentially. The sub-blocks SB11, SB12, and SB13 in the first memory block BLK1 may be erased sub-blocks.

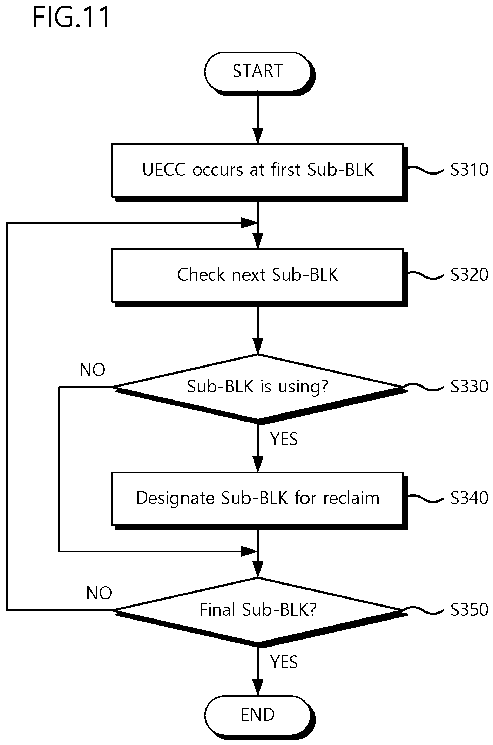

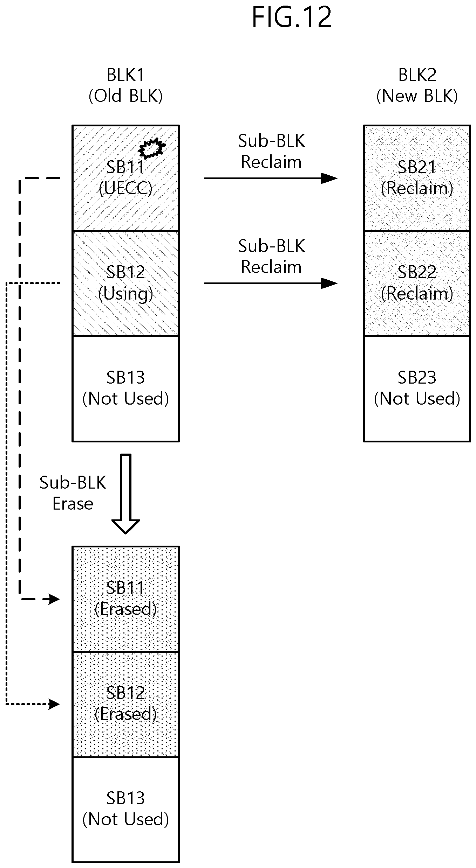

FIGS. 11 and 12 are flowchart and diagram illustrating an example embodiment of designating a using sub-block by the sub-block managing module shown in FIG. 6 as a reclaim sub-block. Referring to FIG. 12, the first memory block BLK1 may include three sub-blocks SB11, SB12, and SB13; and the second memory block BLK2 may include three sub-blocks SB21, SB22, and SB23. The flash memory 1100 may designate a using sub-block in the first memory block BLK1 as a reclaim sub-block under the control of the sub-block managing module 2000. Additionally, the sub-block managing module 2000 may erase reclaim sub-blocks in the first memory block BLK1 concurrently or sequentially.

In operation S310, a UECC may occur in the first sub-block in the first memory block BLK1. Referring to FIG. 12, the first sub-block may be SB11. The sub-block managing module 2000 may determine a UECC when error bits of the first sub-block exceed the allowable range (threshold). The sub-block managing module 2000 may manage a sub-block reclaim operation and/or a sub-block erase operation of the flash memory 1100 when a UECC occurs in the first sub-block SB11.

In operation S320, the sub-block managing module 2000 may check the next sub-block in the first memory block (BLK1). The sub-block managing module 2000 may check the second sub-block (e.g., SB12) when a UECC occurs in the first sub-block (e.g., SB11) of the first memory block (BLK1). Here, the second sub-block does not necessarily need to be SB12, but may also be SB13.

In operation S330, the sub-block managing module 2000 may determine whether the second sub-block is a using sub-block. If the second sub-block is using (YES), operation S340 (for reclaim) may be performed. If the second sub-block is not used (NO), operation S340 may be skipped and operation S350 may be performed. The sub-block managing module 2000 may determine whether the second sub-block (e.g., SB12) is a using sub-BLK. For example, the sub-block managing module 2000 may determine whether the second sub-block is 'using' by checking the programmed page and the page in an erased state.

In operation S340, the sub-block managing module 2000 may designate the second sub-block (e.g., SB12) as a reclaim sub-block if it is a using sub-block. If the second sub-block is a not-used sub-block, the sub-block managing module 2000 may, for example, not designate it as a reclaim sub-block. In operation S350, the sub-block managing module 2000 may determine whether the second sub-block is the final sub-block. If the second sub-block is the final (YES), the sub-block managing module 2000 may end the operation of designating the reclaim sub-block. The sub-block managing module 2000 may perform operation S320 if the second sub-block is not the final (NO).

The sub-block managing module 2000 may check the third sub-block (e.g., SB13) in operation S320. If the third sub-block is a "not-used" sub-block, the sub-block managing module 2000 may omit designating it as a reclaim sub-block. Finally, the sub-block managing module 2000 may reclaim sub-blocks designated as reclaim sub-blocks to the second memory block BLK2.

If a UECC occurs in sub-block SB11, all using sub-blocks SB12 may be reclaimed to the second memory block (BLK2). Sub-block SB11 of the first memory block BLK1 may be reclaimed to sub-block SB21 of the second memory block BLK2. The using sub-block SB12 may be reclaimed to sub-block SB22.

The sub-block managing module 2000 may perform a sub-block erase operation following the sub-block reclaim operation. The sub-block managing module 2000 may simultaneously erase the designated sub-blocks SB11 and SB12 in the first memory block BLK1 or erase them sequentially. The designated sub-blocks SB11 and SB12 of the first memory block BLK1 may be erased sub-blocks.

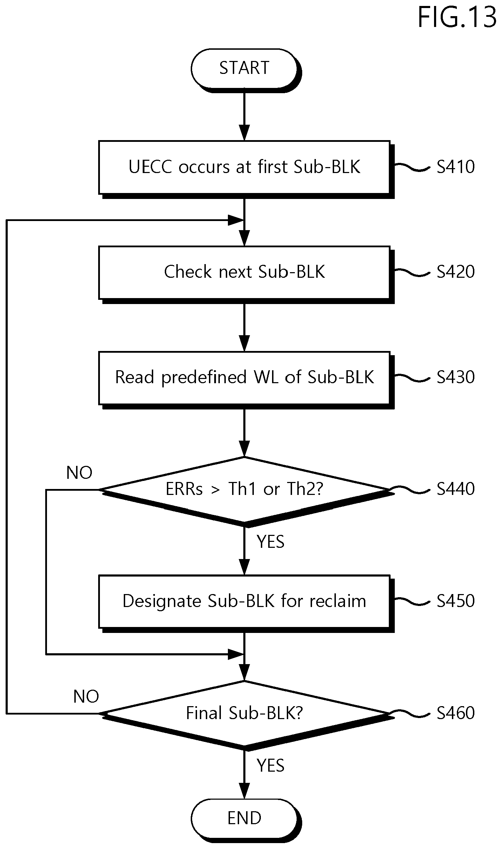

FIGS. 13 to 16 are flowchart and diagrams illustrating an example embodiment in which the sub-block managing module shown in FIG. 6 designates a reclaim sub-block based on the number of error bits of the sub-blocks. Referring to 13 to 16, the first memory block BLK1 may include three sub-blocks SB11, SB12, and SB13, and the second memory block BLK2 may include three sub-blocks SB21, SB22, and SB23. As described hereinabove, the flash memory 1100 may designate a reclaim sub-block based on the number of error bits (ERRs) of the sub-blocks in the first memory block (BLK1) under the control of the sub-block managing module 2000. Additionally, the sub-block managing module 2000 may erase reclaim sub-blocks in the first memory block BLK1 concurrently or sequentially.

In operation S410, UECC may occur in the first sub-block in the first memory block BLK1. The first sub-block may be SB11. The sub-block managing module 2000 may determine UECC when error bits of the first sub-block exceed the allowable range (or threshold). The sub-block managing module 2000 may manage a sub-block reclaim operation and/or a sub-block erase operation of the flash memory 1100 when a UECC occurs in the first sub-block.

In operation S420, the sub-block managing module 2000 may check the next sub-block in the first memory block (BLK1). The sub-block managing module 2000 may check the second sub-block (e.g., SB12) when UECC occurs in the first sub-block (e.g., SB11) of the first memory block (BLK1). Here, the second sub-block does not necessarily have to be SB12, but may also be SB13.

In operation S430, the sub-block managing module 2000 may read a predefined word line of the second sub-block. Here, the sub-block managing module 2000 may designate the predefined word line in various ways. For example, the sub-block managing module 2000 may pre-designate the first programmed word line in the using sub-block (e.g., SB12). Alternatively, the sub-block managing module 2000 may pre-designate the word line with the weakest error correction. Alternatively, the sub-block managing module 2000 may pre-designate the word line of the second sub-block at the same location as the word line of the first sub-block where UECC occurred.

In operation S440, the sub-block managing module 2000 may determine whether the number of error bits (ERRs) of a pre-designated word line of the second sub-block is greater than the first threshold (Th1). If the number of error bits (ERRs) is greater than the first threshold (Th1) (YES), operation S450 may be performed. If not more (NO), operation S460 may be performed. The sub-block managing module 2000 may find the number of error bits (ERRs) of the second sub-block (e.g., SB12) in various ways. For example, the sub-block managing module 2000 may find the number of error bits using an ECC circuit (see FIG. 6, 1240).

The sub-block managing module 2000 may set the threshold differently depending on whether the second sub-block is a using sub-block or a not-used sub-block. If a sub-block is using, the first threshold (Th1) may be applied. If a sub-block is a not-used sub-block, the second threshold (Th2) may be applied. The first threshold Th1 may be greater than the second threshold Th2.

In operation S450, the sub-block managing module 2000 may designate the second sub-block (e.g., SB12) as a reclaim sub-block when the number of error bits (ERRs) is greater than the first threshold (Th1). The sub-block managing module 2000 may, for example, not designate the second sub-block as a reclaim sub-block if the number of error bits (ERRs) of the second sub-block is not greater than the first threshold (Th1).

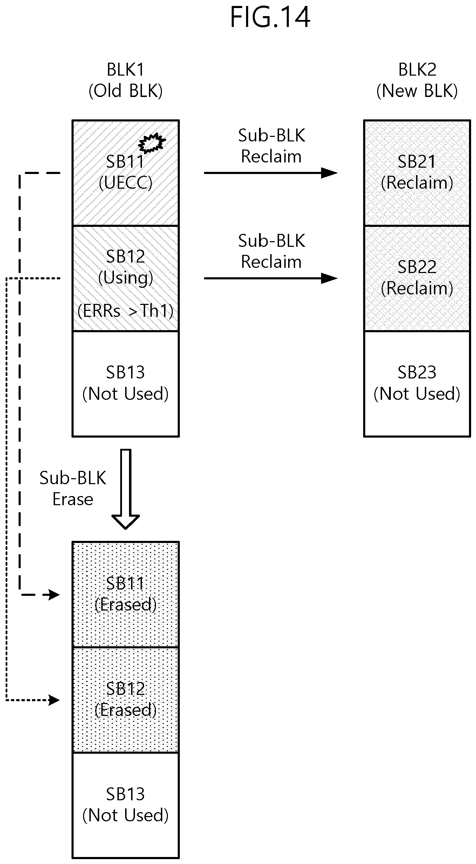

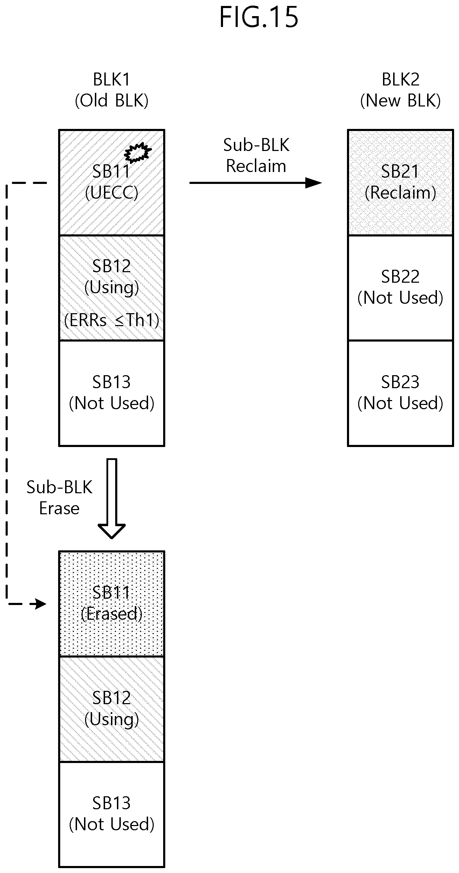

Referring to FIG. 14, the sub-block managing module 2000 may designate sub-block SB12 as a reclaim sub-block because the number of error bits (ERRs) of sub-block SB12 is greater than the first threshold (Th1). Referring to FIG. 15, the sub-block managing module 2000 may, for example, not designate sub-block SB12 as a reclaim sub-block because the error bit number (ERRs) of sub-block SB12 is less than or equal to the first threshold (Th1).

In operation S460, the sub-block managing module 2000 may determine whether the second sub-block is the final sub-block. If the second sub-block is the final (YES), the sub-block managing module 2000 may end the operation of designating the reclaim sub-block. The sub-block managing module 2000 may perform operation S420 if the second sub-block is not the final (NO). The sub-block managing module 2000 may check the third sub-block (e.g., SB13) in operation S420. If the third sub-block is a not-used sub-block, the sub-block managing module 2000 may designate a reclaim sub-block by applying a second threshold (Th2).

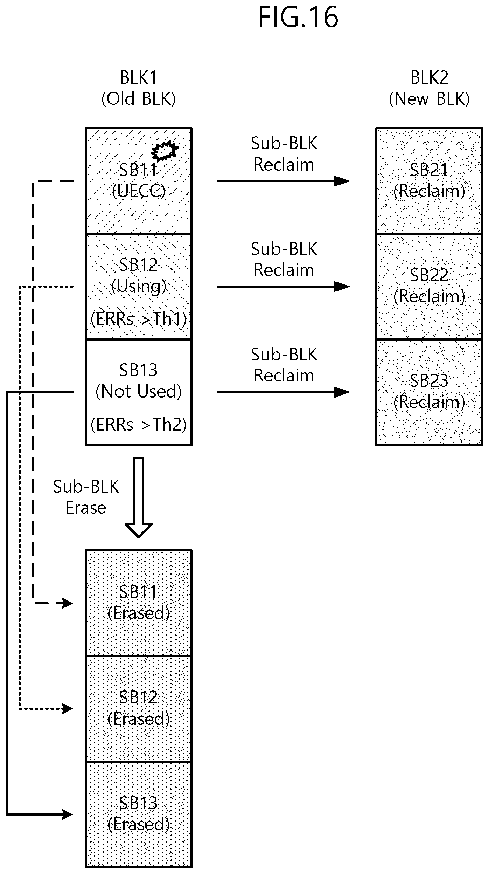

Referring to FIG. 16, the sub-block managing module 2000 may designate sub-block SB13 as a reclaim sub-block because the number of error bits (ERRs) of sub-block SB13 is greater than the second threshold (Th2). The sub-block managing module 2000 may reclaim the sub-blocks SB1 1, SB12, and SB13 designated as reclaim sub-blocks to the second memory block BLK2. When a UECC occurs in sub-block SB11, the sub-block managing module 2000 may perform a reclaim operation based on the number of error bits of the remaining sub-blocks SB12 and SB13. The sub-block managing module 2000 may set different threshold values for the using sub-block SB12 and the threshold value for the not-used sub-block SB13. The sub-block managing module 2000 may perform a sub-block erase operation following the sub-block reclaim operation. The sub-block managing module 2000 may erase designated sub-blocks in the first memory block BLK1 concurrently or sequentially. The designated sub-blocks of the first memory block (BLK1) may be erased sub-block.

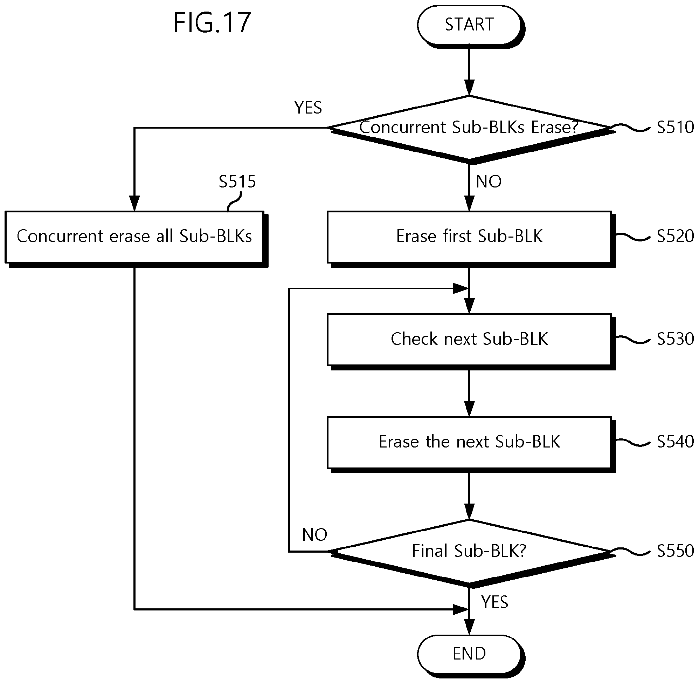

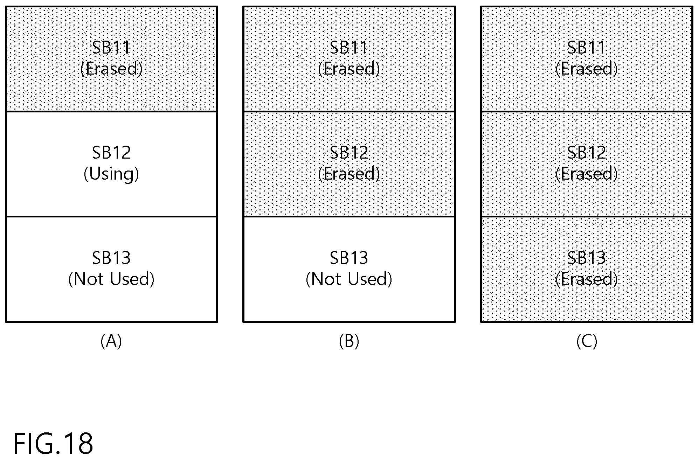

FIGS. 17 and 18 are flowchart and diagram illustrating an example embodiment of a sub-block erase operation of the sub-block managing module shown in FIG. 6. Referring to FIG. 18, the first memory block BLK1 may include three sub-blocks SB11, SB12, and SB13. SB11 may be a sub-block in which UECC occurred. SB12 may be a using sub-block. And SB13 may be a not-used sub-block.

In operation S510, the sub-block managing module 2000 may determine whether to concurrently erase the sub-blocks. After the sub-block reclaim operation is completed, the sub-block managing module 2000 may erase the sub-blocks in the first memory block BLK1 concurrently or sequentially. If the sub-blocks are concurrently erased (YES), operation S515 may be performed. If not erased concurrently (NO), operation S520 may be performed.

In operation S515, the sub-block managing module 2000 may control the flash memory 1100 to concurrently erase all sub-blocks. Here, erase blocks that are concurrently erased may be all sub-blocks in the first memory block BLK1. Alternatively, the sub-block managing module 2000 may concurrently erase sub-blocks designated as reclaim sub-blocks.

In operation S520, the sub-block managing module 2000 may erase the first sub-block. Referring to (A) of FIG. 18, the first sub-block may be sub-block SB11 in the first memory block BLK1. The sub-block SB11 is a sub-block in which UECC occurs and may be erased first.

In operation S530, the sub-block managing module 2000 may check the next sub-block in the first memory block (BLK1). The sub-block managing module 2000 may erase the first sub-block (e.g., SB11) of the first memory block BLK1 and then check the second sub-block. Here, the second sub-block may be designated among all sub-blocks in the first memory block BLK1 or among reclaim sub-blocks. The second sub-block does not necessarily have to be SB12, but may be SB13.

In operation S540, the sub-block managing module 2000 may erase the second sub-block. Referring to (B) of FIG. 18, the second sub-block may be sub-block SB12 in the first memory block BLK1. The sub-block SB12 is a using sub-block and may be erased after SB11. If the sub-block managing module 2000 performs an erase operation only on reclaim sub-blocks and sub-block SB12 is not designated as a reclaim sub-block, the sub-block managing module 2000 may, for example, not erase the sub-block SB12.

In operation S550, the sub-block managing module 2000 may determine whether the second sub-block is the final sub-block. If the second sub-block is the final (YES), the sub-block managing module 2000 may end the sub-block erase operation. The sub-block managing module 2000 may perform operation S530 if the second sub-block is not the final (NO).

The sub-block managing module 2000 may check the third sub-block (e.g., SB13) in operation S530. The sub-block managing module 2000 may erase sub-block SB12 of the first memory block BLK1 and then check sub-block SB13. The sub-block managing module 2000 may erase sub-block SB13. Referring to (C) of FIG. 18, sub-block SB12 is a not-used sub-block and may be erased after SB12. If the sub-block managing module 2000 performs an erase operation only on reclaim sub-blocks and sub-block SB13 is not designated as a reclaim sub-block, the sub-block managing module 2000 may, for example, not erase sub-block SB13.

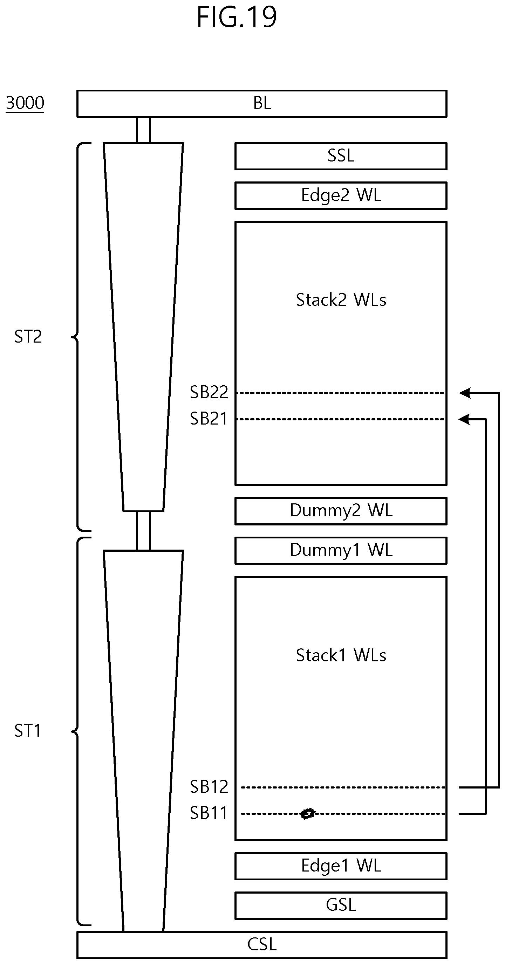

FIG. 19 is a diagram illustrating an example embodiment of a flash memory having a multi-stack structure (from a cross-sectional perspective). Referring to FIG. 19, the flash memory 3000 may have a first stack ST1 and a second stack ST2. The first stack ST1 may be located at the bottom, and the second stack ST2 may be located at the top. A pillar of the flash memory 3000 may be formed by bonding the first and second stacks ST1 and ST2. A plurality of dummy word lines (e.g., Dummy1 WL and Dummy2 WL) may be included at junctions of the first and second stacks ST1 and ST2. The first stack ST1 may be positioned between the common source line CSL and the first dummy word line Dummy1 WL. The second stack ST2 may be positioned between the second dummy word line Dummy2 WL and the bit line BL. The first stack ST1 may include a ground selection line GSL, a first edge word line Edge1 WL, and first stack word lines Stack1 WLs. The second stack ST2 may include second stack word lines Stack2 WLs and second edge word lines Edge2 WL. Memory cells connected to the first and second edge word lines Edge1 WL and Edge2 WL may store bit data different from the other memory cells. For example, memory cells connected to the first and second edge word lines Edge1 WL and Edge2 WL may be SLC or MLC, and memory cells connected to the other word lines may be TCL or QLC.

When a UECC occurs in the first sub-block SB11 of the first stack ST1, the sub-block managing module 2000 may determine whether the second sub-block SB12 is a reclaim sub-block. If the second sub-block SB12 is a reclaim sub-block, the sub-block management module 2000 may reclaim the first and second sub-blocks (SB11, SB12) to the third and fourth sub-blocks (SB21, SB22) of the second stack ST2. After performing a sub-block reclaim operation, the sub-block managing module 2000 may erase the sub-blocks SB11 and SB12 of the first stack ST1 concurrently or sequentially.

The sub-block managing module 2000 may move data stored in deteriorated sub-blocks of the first stack (ST1) to sub-blocks of the second stack (ST2) through a sub-block reclaim operation. The sub-block managing module 2000 may reduce WAF (Write Amplification Factor) and increase QoS (Quality of Service) by performing a sub-block reclaim operation in flash memory with a multi-stack structure.

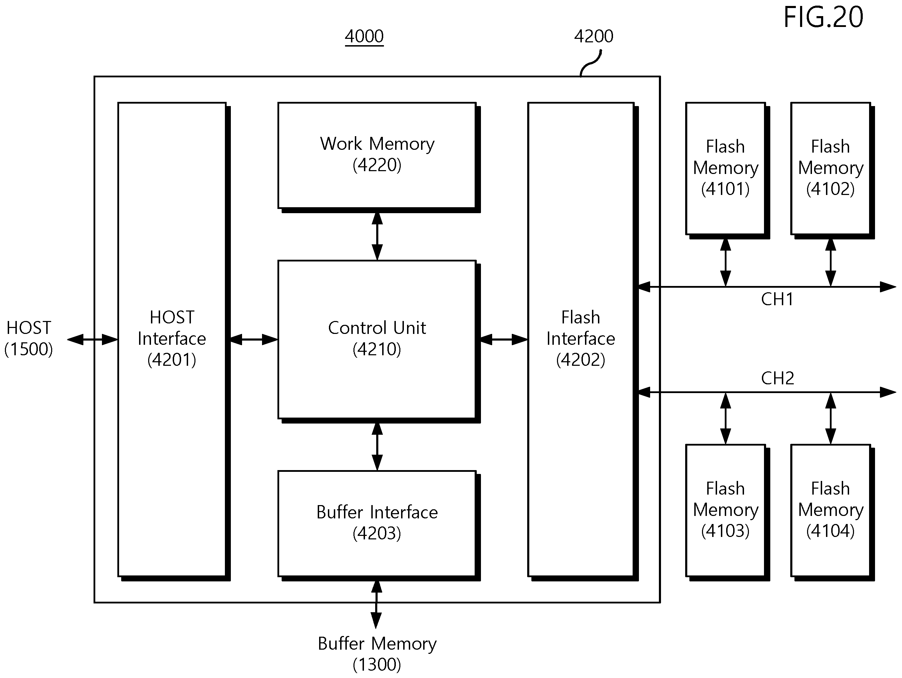

FIG. 20 is a block diagram illustrating an example in which a storage device according to an embodiment of the present disclosure is implemented with a solid state drive (SSD). Referring to FIG. 20, an SSD 4000 may include a plurality of flash memories 4101 to 4104 and an SSD controller 4200. The first and second flash memories 4101 and 4102 may be connected with the SSD controller 4200 through a first channel CH1. The third and fourth flash memories 4103 and 4104 may be connected with the SSD controller 4200 through a second channel CH2. The number of channels connected with the SSD controller 4200 may be 2 or more. The number of flash memories connected with one channel may be 2 or more.

The SSD controller 4200 may include a host interface 4201, a flash interface 4202, a buffer interface 4203, a control unit 4210, and a work memory 4220. The SSD controller 4200 may be connected with a host 1500 through the host interface 4201. Depending on a request of the host 1500, the SSD controller 4200 may write data in the corresponding flash memory or may read data from the corresponding flash memory.

The SSD controller 4200 may be connected with the plurality of flash memories 4101 to 4104 through the flash interface 4202 and may be connected with a buffer memory 1300 through the buffer interface 4203. The flash interface 4202 may provide data, which are temporarily stored in the buffer memory 1300, to the flash memories through the channels CH1 and CH2. The flash interface 4202 may transfer the data read from the flash memories 4101 to 4104 to the buffer memory 1300.

The control unit 4210 may analyze and process the signal received from the host 1500. The control unit 4210 may control the host 1500 or the flash memories 4101 to 4104 through the host interface 4201 or the flash interface 4202. The control unit 4210 may control operations of the flash memories 4101 to 4104 by using firmware for driving the SSD 4000.

The SSD controller 4200 may manage data to be stored in the flash memories 4101 to 4104. In the sudden power-off event, the SSD controller 4200 may back the data stored in the work memory 4220 or the buffer memory 1300 up to the flash memories 4101 to 4104. In addition, the SSD controller 4200 may include the previously described sub-block managing module 2000 within the control unit 4210. The sub-block managing module 2000 may perform a sub-block reclaim operation in each flash memory 4101 to 4104 or between different flash memories. The sub-block managing module 2000 may designate reclaim sub-blocks based on the deterioration level of other sub-blocks within the same memory block and perform a reclaim operation to another memory block.

As described hereinabove, the storage device may perform a sub-block reclaim operation between memory blocks. The sub-block managing module may check the reclaim operation of other sub-blocks within the same memory block in advance, designate the reclaim sub-blocks according to the level of degradation, and perform the reclaim operation to other memory blocks. According to the present disclosure, the storage device may reduce performance degradation due to uncorrectable errors by performing a reclaim operation.

While the present disclosure has been described with reference to embodiments thereof, it will be apparent to those of ordinary skill in the art that various changes and modifications may be made thereto without departing from the scope of the present disclosure as set forth in the following claims.

## Claims

1. A non-volatile integrated circuit memory device, comprising:
a first memory block having first and second memory sub-blocks therein;
a second memory block having third and fourth memory sub-blocks therein; and
a sub-block manager configured to:
determine whether the second memory sub-block is a reclaim sub-block when the first memory sub-block has an uncorrectable error therein; and
reclaim the first and second memory sub-blocks to the third and fourth memory sub-blocks, respectively, in response to determining that the second memory sub-block is a reclaim sub-block.

2. The device of claim 1, wherein the first and second memory sub-blocks are erased in response to reclamation of the first and second memory sub-blocks.

3. The device of claim 1 or 2, wherein the first and second memory sub-blocks are sequentially erased in response to reclamation of the first and second memory sub-blocks.

4. The device of claim 1, 2, or 3, wherein the sub-block manager is configured to designate the second memory sub-block as a reclaim sub-block when the second memory sub-block is a using sub-block, but not when the second memory sub-block is a not-used sub-block.

5. The device of any one of claims 1 to 4, wherein the sub-block manager is configured to not designate the second memory sub-block as a reclaim sub-block when the second memory sub-block is a using sub-block or a non-used sub-block.

6. The device of any one of claims 1 to 5, wherein the sub-block manager is configured to determine whether or not the second memory sub-block is a reclaim sub-block based on the number of error bits of the second memory sub-block.

7. The device of claim 6, wherein the sub-block manager is further configured to compare the number of error bits of a predetermined word line of the second memory sub-block against a threshold value, and then determine whether the second memory sub-block is a reclaim sub-block according to a result of the comparison.

8. The device of claim 7, wherein the predetermined word line is one of, the first programmed word line within the second memory sub-block, a word line determined based on an error correction level, a word line determined according to a height of the word line where an uncorrectable error occurs in the first memory sub-block.

9. The device of any one of claims 7 to 8, wherein the threshold value changes according to a program-erase cycle.

10. The device of any one of claims 7 to 9, wherein the threshold value varies depending on whether the second memory sub-block is a using sub-block or a not-used sub-block.

11. The device of any one of claims 1 to 10, wherein:
the first memory block has first to third memory sub-blocks therein;
the second memory block has fourth to sixth memory sub-blocks therein;
wherein when the first memory sub-block is an uncorrectable error memory sub-block, the storage device is configured to reclaim the first and second memory sub-blocks to the fourth and fifth memory sub-blocks, or to reclaim the first to third memory sub-blocks to the fourth to sixth memory sub-blocks, respectively.

12. The device of claim 11, wherein the storage device is configured to designate the second and third memory sub-blocks as reclaim blocks when the second or third memory sub-block is a using sub-block, but not when the second or third memory sub-block is a not-used sub-block

13. A storage device, comprising:
a first memory block having first to third memory sub-blocks therein; and
a second memory block having fourth to sixth memory sub-blocks therein;
wherein the second memory sub-block is a using memory sub-block and the third memory sub-block is a not-used memory sub-block; and
wherein when the first memory sub-block is an uncorrectable error memory sub-block, the storage device is configured to reclaim the first to third memory sub-blocks to the fourth to sixth memory sub-blocks, respectively.

14. The device of Claim 13,
wherein the storage device is configured to reclaim the first to third memory sub-blocks to the fourth to sixth memory sub-blocks, respectively, and then concurrently erase the first to third memory sub-blocks.

15. The storage device of claim 13 or 14,
wherein the storage device is configured to reclaim the first to third memory sub-blocks to the fourth to sixth memory sub-blocks, respectively, and then sequentially erase the first and second memory sub-blocks.
